# EUROPEAN PATENT APPLICATION

(11) **EP 2 157 585 A1**
(43) Date of publication of application: **24.02.2010**
(21) Application number: 08740672.4
(22) Date of filing: 18.04.2008
(51) Int. Cl.: H01B 19/00, B32B 18/00, C03C 3/085, C03C 3/087, C03C 3/091, C03C 3/093, C03C 4/16, C04B 35/111, C04B 35/14, H01G 4/12, H05K 3/46

(54) **METHOD FOR PRODUCTION OF LAMINATED DIELECTRIC MATERIAL**

(30) Priority: 25.04.2007 JP 2007115724
(71) Applicant: Asahi Glass Company, Limited, Chiyoda-ku Tokyo 100-8405 (JP)
(72) Inventor: TOMENO, Satoru, Tokyo 100-8405 (JP); OSAKI, Yasuko, Tokyo 100-8405 (JP); WATANABE, Kazuo, Tokyo 100-8405 (JP); NAKAYAMA, Katsuyoshi, Tokyo 100-8405 (JP)
(74) Representative: Müller-Boré & Partner Patentanwälte
(86) International application number: PCT/JP2008/057625
(87) International publication number: WO 2008/133213

(57) **Abstract**

To provide a method for producing a laminated dielectric material using a stabilized glass.

A method for producing a laminated dielectric material wherein the absolute value of the difference in the average linear expansion coefficient at from 50 to 350°C between any adjacent dielectric layers is at most 15×10⁻⁷/°C; at least one raw material layer before firing, comprises, as represented by mass%, from 50 to 80% of glass powder and from 20 to 50% of alumina powder; said glass powder comprises, as represented by mol%, from 45 to 60% of SiO₂, from 2 to 10% of Al₂O₃, from 10 to 30% of BaO, from 10 to 20% of ZnO, etc.; and each of glass powders contained in two raw material layers adjacent to said raw material layer, comprises, as represented by mol%, from 45 to 55% of SiO₂, from 2 to 20% of Al₂O₃, from 20 to 45% of MgO, etc.; and the glass transition temperature of the latter glass powder is higher by at least 50°C than that of the former.

## Description

### TECHNICAL FIELD

The present invention relates to a production method suitable for producing, by low temperature firing, a laminated dielectric material suitable for substrates for circuits or antennas.

### BACKGROUND ART

As a substrate for e.g. a circuit or antenna for a small size electronic equipment such as a cell phone to be used in a high frequency wave region such as a microwave region, a multilayer dielectric substrate (low temperature co-fired ceramic substrate) is used which has a layered structure wherein an electrical conductive section made of a conductor composed mainly of silver, copper or the like, is formed on the surface of the substrate, between layers or in a layer.

Such a low temperature co-fired ceramic substrate is produced by firing a glass ceramic material and a conductor material simultaneously, but since shrinkage behaviors by firing are different between the glass ceramic material and the conductor material, there is a problem of deformation of the substrate, or a problem such that the shrinkage by firing is substantial, whereby the dimensional precision tends to be poor. As a method to solve such a problem, a method is used wherein firing is carried out while sandwiching and constraining the laminate with a material which is not sintered at the temperature for firing the glass ceramic material.

However, in such a method of using a constraining material which is not sintered at the firing temperature, the constraining layer must be removed after the firing. As the method to solve such a problem, a method is proposed wherein at least two types of glass ceramics material different in the shrinkage-starting temperature, are laminated and fired (e.g. Patent Document 1). By such a method, when a material having a low shrinkage-starting temperature undergoes shrinkage, a material having a high shrinkage-starting temperature plays a role of a constraining layer, and when the material having a high shrinkage-starting temperature undergoes shrinkage, the layer having shrinkage already completed becomes a constraining layer.

Patent Document 1: JP-A-2003-69236

### DISCLOSURE OF THE INVENTION

### PROBLEM TO BE SOLVED BY THE INVENTION

In order to obtain 500 g of glass of sample No. 1 disclosed in Table 1 of Patent Document 1 (composition by mass% being 18% of SiO₂, 18% of B₂O₃ 0.6% of Al₂O₃, 45% of MgO, 0.4% of CaO, 15% of BaO, 0.1 % of ZrO₂, 1.9% of SnO₂ and 1% of P₂O₅; composition by mol% being 16.6% of SiO₂, 14.3% of B₂O₃, 0.3% of Al₂O₃, 61.8% of MgO, 0.4% of CaO, 5.4% of BaO, 0.04% of ZrO₂, 0.7% of SnO₂ and 0.4% of P₂O₅), the present inventors prepared and mixed powders of SiO₂, MgO, B₂O₃, Al₂O₃, CaCO₃, BaCO₃, SnO₂, ZrO₂ and magnesium methaphosphate, and the mixture was melted at 1,600°C by means of a platinum crucible. Then, the melt was cast and rapidly cooled on a stainless steel roller. When the crucible was inspected after casting the melt, devitrified glass was observed in the crucible. Further, devitrification was observed also in some parts of the glass obtained by the rapid cooling.

This result indicates that the glass disclosed in Patent Document 1 is not necessarily stable one.

It is an object of the present invention to provide a method for producing a laminated dielectric material capable of solving such a problem.

### MEANS TO SOLVE THE PROBLEM

The present invention provides a method for producing a laminated dielectric material wherein n dielectric layers (where n is an integer of at least 3) are laminated so that the absolute value of the difference in the average linear expansion coefficient at from 50 to 350°C between any adjacent dielectric layers is at most 15×10⁻⁷/°C, which comprises laminating and firing n glass powder-containing raw material layers which, upon being fired, become the above dielectric layers, wherein at least one glass powder-containing raw material layer among the glass powder-containing raw material layers to become the second to (n-1)th dielectric layers, comprises, as represented by mass percentage, from 50 to 80% of glass powder and from 20 to 50% of alumina powder; said glass powder comprises, as represented by mol% based on the following oxides, from 45 to 60% of SiO₂, from 0 to 10% of B₂O₃, from 2 to 10% of Al₂O₃, from 0 to 5% of CaO, from 10 to 30% of BaO, from 10 to 20% of ZnO, from 0 to 5% of Li₂O+Na₂O+K₂O, and from 0 to 5% of TiO₂+ZrO₂+SnO₂ (hereinafter, this glass powder may sometimes be referred to as the glass powder A); and each of glass powders contained in two glass powder-containing raw material layers adjacent to said glass powder-containing raw material layer, comprises, as represented by mol% based on the following oxides, from 45 to 55% of SiO₂, from 0 to 5% of B₂O₃, from 2 to 20% of Al₂O₃, from 20 to 45% of MgO, from 0 to 20% of CaO+SrO, from 0 to 10% of BaO, from 0 to 15% of ZnO, and from 0 to 10% of TiO₂+ZrO₂+SnO₂ (hereinafter, this glass powder may sometimes be referred to as the glass powder B) and its glass transition temperature is higher by at least 50°C than the glass transition temperature of the glass powder i.e. the glass powder A of the glass powder-containing raw material layer sandwiched by said two glass powder-containing raw material layers (first method).

Further, the present invention provides a method for producing a laminated dielectric material wherein n dielectric layers (where n is an integer of at least 3) are laminated so that the absolute value of the difference in the average linear expansion coefficient at from 50 to 350°C between any adjacent dielectric layers is at most 15×10⁻⁷/°C, which comprises laminating and firing n glass powder-containing raw material layers which, upon being fired, become the above dielectric layers, wherein at least one glass powder-containing raw material layer among the glass powder-containing raw material layers to become the second to (n-1)th dielectric layers, contains a glass powder i.e. the glass powder B which comprises, as represented by mol% based on the following oxides, from 45 to 55% of SiO₂, from 0 to 5% of B₂O₃, from 2 to 20% of Al₂O₃, from 20 to 45% of MgO, from 0 to 20% of CaO+SrO, from 0 to 10% of BaO, from 0 to 15% of ZnO, and from 0 to 10% of TiO₂+ZrO₂+SnO₂; and each of two glass powder-containing raw material layers adjacent to said glass powder-containing raw material layer, comprises, as represented by mass percentage, from 50 to 80% of glass powder and from 20 to 50% of alumina powder, wherein said glass powder i.e. the glass powder A comprises, as represented by mol% based on the following oxides, from 45 to 60% of SiO₂, from 0 to 10% of B₂O₃, from 2 to 10% of Al₂O₃, from 0 to 5% of CaO, from 10 to 30% of BaO, from 10 to 20% of ZnO, from 0 to 5% of Li₂O+Na₂O+K₂O, and from 0 to 5% of TiO₂+ZrO₂+SnO₂ and its glass transition temperature is lower by at least 50°C than the glass transition temperature of the glass powder of the glass powder-containing raw material layer sandwiched by said two glass powder-containing raw material layers (second method).

Further, the present invention provides the first or second method wherein TiO₂+ZrO₂+SnO₂ in the glass powder B is from 0 to 5 mol%.

In the first method, the two glass powder-containing raw material layers adjacent to the glass powder-containing raw material layer containing the glass powder A, contain the glass powder B. Whereas, in the second method, two glass powder-containing raw material layers adjacent to the glass powder-containing raw material layer (hereinafter sometimes referred to as the raw material layer B) containing the glass powder B in the first method, are made of the glass powder-containing raw material layer (hereinafter sometimes referred to as the raw material layer A) containing the glass powder A in the first method.

Accordingly, in the following, the first method will be described, and the description with respect to the second method may be regarded to be the same as the description with respect to the first method.

### EFFECTS OF THE INVENTION

According to the present invention, a multilayer dielectric substrate can be produced to undergo less shrinkage, whereby its dimensional precision can be made high.

According to a preferred embodiment of the present invention, the dielectric loss tangent at a high frequency at a level of 9GHz of the dielectric material of the multilayer dielectric substrate can be made small.

### BEST MODE FOR CARRYING OUT THE INVENTION

In the present invention, a glass powder-containing raw material layer (hereinafter sometimes referred to simply as a raw material layer) is one having a glass powder dispersed therein, and usually, a glass ceramic composition having such a glass powder mixed with a ceramic powder, is dispersed therein. Here, the ceramic powder is typically a powder of ceramics having a melting point of at least 1,000°C or a powder of glass having a softening point (Ts) of at least 1,000°C.

In the method of the present invention, a green sheet method is usually employed. In the following, the present invention will be described with respect to a case where a green sheet method is employed, but it should be understood that the present invention is by no means restricted thereto. Further, in such a case, the raw material layer is made of a single green sheet or one having a plurality of the same green sheets laminated.

A green sheet having a glass ceramic composition dispersed may, for example, be prepared as follows. That is, a glass ceramic composition as a component to constitute the raw material layer is mixed with a resin such as a polyvinyl butyral or an acrylic resin and a solvent such as toluene, xylene or butanol and further, as the case requires, a plasticizer, such as dibutyl phthalate, dioctyl phthalate, triethylene glycol or polyethylene glycol or dispersant may be added and mixed to prepare a slurry. Then, such a slurry is formed into a sheet on a film of e.g. polyethylene terephthalate (PET) by e.g. a doctor blade method. This sheet-form product is dried to remove the solvent thereby to obtain a green sheet.

In a case where such a green sheet method is employed, the raw material layer comprises the resin and the glass powder, ceramic powder, etc. dispersed therein.

A plurality of the same green sheets are laminated to form a raw material layer. In a case where n pieces (n≧3) of raw material layers thus obtained are laminated and fired to form a laminated dielectric material, it is usual that the above-mentioned laminated raw material layers are heated to from 80 to 120°C and pressed to form one (a laminate material to be fired) which is then fired.

The firing is carried out usually at a temperature of from 800 to 900°C, typically from 850 to 880°C, for from 5 to 120 minutes.

Further, on a green sheet, as the case requires, a wiring conductor or the like may be preliminarily formed by screen printing or the like by using a silver paste or the like.

The dielectric constant at 9GHz (hereinafter this dielectric constant will be referred to as ε) of each dielectric layer (hereinafter sometimes referred to simply as a dielectric layer) of the laminated dielectric material to be produced by the method of the present invention is typically from 5 to 10, more typically from 6 to 9. Here, ε is a dielectric constant at room temperature, typically at from 20 to 25°C.

In the present invention, the difference (absolute value) in ε between the adjacent dielectric layers in the laminated dielectric material is typically less than 3.

The dielectric loss tangent (hereinafter this dielectric loss tangent will be referred to as tanδ) at 9GHz of the above dielectric layer is preferably at most 0.0050, more preferably at most 0.0030, particularly preferably at most 0.0025.

Here, "dielectric constant at 9GHz" in the present invention is the dielectric constant at (9±1.5)GHz, and the same applies to tanδ.

The glass transition temperature (Tg) of the glass powder A contained in the raw material layer A is lower by at least 50°C than Tg of the glass powder B contained in the raw material layer B adjacent to the raw material layer A. Accordingly, when they are simultaneously fired, the raw material layer A containing the glass powder A having low Tg undergoes shrinkage and becomes dense at a lower temperature, and thereafter, the raw material layer B containing the glass powder B having high Tg undergoes shrinkage and becomes dense, whereby they are mutually constraining so that shrinkage in the plane direction is reduced, and it becomes possible to produce a laminated dielectric substrate with a high dimensional precision.

If the difference (absolute value) in Tg between the glass powders contained in the adjacent raw material layers is less than 50°C, shrinkage of the raw material layer containing the glass powder having high Tg begins before completion of shrinkage of the raw material layer containing the glass powder having low Tg, whereby the constriction tends to be inadequate, and the dimensional precision tends to be low. The difference in Tg is preferably at least 70°C. Further, the difference in Tg is typically at most 120°C. If the difference in Tg is excessively large, the raw material layer containing the glass powder having low Tg tends to be excessively fired, or firing of the raw material layer containing the glass powder having high Tg tends to be inadequate, whereby the desired properties may not be obtained.

In a case where it is desired to further improve the dimensional precision, it is preferred to carry out firing by maintaining the temperature at such a level where the raw material layer containing the glass powder having low Tg undergoes shrinkage but the raw material layer containing the glass powder having high Tg does not undergo shrinkage, and thereafter by maintaining the temperature at a level where the raw material layer containing the glass powder having high Tg undergoes shrinkage. For example, there may be a case where it is preferred to carry out firing by maintaining the temperature at a level of from 740 to 780°C for from 30 to 120 minutes, and then maintaining the temperature at a level of from 850 to 880°C.

In the present invention, the difference (absolute value) in the average linear expansion coefficient (α) at from 50 to 350°C between the adjacent dielectric layers in the laminated dielectric material is set to be at most 15×10⁻⁷/°C, whereby the possibility of cracking in the laminated dielectric material is reduced. The difference in α is preferably at most 10×10⁻⁷/°C, typically at most 5×10⁻⁷/°C.

Here, α of a dielectric layer obtainable by firing the raw material layer B is typically from 70×10⁻⁷ to 90×10⁻⁷/°C, more typically from 75×10⁻⁷ to 85×10⁻⁷/°C.

In the present invention, the thickness of each layer in the laminated dielectric material is typically from 0.1 to 0.8 mm, and when n is an odd number, the thicknesses of the layers which are vertically symmetrically located with the center layer at the center, are preferably equal. For example, in the case of seven layers, the thicknesses of the first and seventh layers, the second and sixth layers, and the third and fifth layers, are preferably equal. Otherwise, the laminated dielectric material is likely to be deformed.

Now, the glass powder-containing raw material layer to be used in the method for producing a laminated dielectric material of the present invention will be described. Unless otherwise specified, the composition of glass will hereinafter be represented by mol% and will be referred to simply as %.

Firstly, the glass powder A contained in the raw material layer A will be described. The 50% particle size (D₅₀) of the glass powder A is preferably from 0.5 to 10 µm. If it is less than 0.5 µm, it may, for example, tends to be difficult to uniformly disperse the glass powder in the green sheet. It is more preferably at least 1 µm. If it exceeds 10 µm, it tends to be difficult to obtain a dense sintered product. It is more preferably at most 4 µm.

Tg of the glass powder A is preferably from 550 to 700°C. If it is lower than 550°C, it tends to be difficult to remove the organic binder (resin) in the green sheet. It is more preferably at least 600°C. If it exceeds 700°C, the shrinkage-starting temperature during the firing tends to be high, the dimensional precision of the laminated dielectric material is likely to be low.

The glass powder A is typically preferably one wherein, when fired at from 850 to 900°C, crystals will precipitate. If no crystals will precipitate, the mechanical strength of the sintered product (the dielectric layer) will be low, or the dimensional precision of the laminated dielectric material tends to be low.

Further, the crystallization peak temperature (Tc) as measured by DTA is preferably at most 950°C. If it exceeds 950°C, the dimensional precision of the laminated dielectric material is likely to be low.

The glass powder A is preferably such that when it is fired, BaAl₂Si₂O₈ crystals will precipitate. When it is such a powder, tanδ of the fired product can be made small.

Further, in a case where it is desired to increase the mechanical strength, it is preferably one wherein in addition to the above crystals, anorthite crystals will precipitate.

The composition of the glass powder A will be described below. In this specification, "%" in the composition of the glass powder means "mol%" unless otherwise specified.

SiO₂ is a network former of glass and is essential. If it is less than 45%, the chemical durability tends to be inadequate, or tanδ of the fired product is likely to be large. It is preferably at least 50%. If it exceeds 60%, Tg or Tc tends to be too high. It is preferably at most 58%.

B₂O₃ is not essential, but may be contained up to 10% in order to e.g. stabilize the glass. If it exceeds 10%, tanδ of the fired product is likely to be large, or the chemical durability is likely to be low. It is preferably at most 8%. In a case where B₂O₃ is contained, it is preferably at least 2%.

Al₂O₃ is a component to increase the stability or chemical durability of the glass and is essential. If it is less than 2%, the glass tends to be unstable. It is preferably at least 3%. If it exceeds 10%, Ts or Tg tends to be too high, or the glass tends to be unstable. It is preferably at most 8%, more preferably at most 7%.

CaO is not essential, but may be contained up to 5% for the purpose of e.g. stabilizing the glass or lowering tanδ of the fired product. Further, CaO is a component constituting anorthite, and when it is desired to precipitate anorthite crystals, its content is preferably at least 1 %.

BaO is a component constituting BaAl₂Si₂O₈ crystals and is essential. If it is less than 10%, such crystals tend to hardly precipitate. It is typically at least 14%, and in a case where it is desired to increase α, it is preferably at least 17%. If it exceeds 30%, the glass is likely to be unstable. It is preferably at most 25%.

ZnO is a component to lower Ts or Tg and is essential. If it is less than 10%, such Ts or Tg tends to be high. It is typically at least 14%. If it exceeds 20%, the chemical durability, particularly the acid resistance, of the glass tends to be low. It is preferably at most 18%.

Each of Li₂O, Na₂O and K₂O is not essential, but they may be contained in a total amount of up to 5% in order to e.g. lower Ts or Tg or increase the crystallization ratio of the fired product. If the total amount exceeds 5%, tanδ is likely to be large, or the electrical insulating property is likely to be low. It is preferably at most 3%. When these components are to be contained, the total of their contents is preferably at least 0.5%.

Each of TiO₂, ZrO₂ and SnO₂ is not essential, but they may be contained in a total amount of 5% in order to e.g. increase the chemical durability of the glass, to accelerate the crystallization during the firing, etc. When such components are to be contained, the total of their contents is preferably at least 0.5%.

The glass powder A consists essentially of the above components, but may contain other components within a range not to impair the purpose of the present invention. In a case where such other components are to be contained, the total of their contents is preferably at most 10%.

Further, the glass powder A contains no lead oxide.

The composition of the glass ceramic composition constituting the raw material layer A (hereinafter referred to as the glass ceramic composition A) will be described by using mass percentage.

The glass powder A is a component to increase the denseness of the fired product. If it is less than 50%, the denseness tends to be inadequate. It is preferably at least 55%. If it exceeds 80%, the mechanical strength tends to be inadequate, or the shrinkage of the laminate tends to be large. It is preferably at most 75%.

The alumina powder is a component to increase the strength of the fired product or to maintain the shape of the fired product. If it is less than 20%, the strength of the fired product tends to be low, or the shrinkage of the laminate tends to be large. If it exceeds 50%, the denseness of the fired product tends to be inadequate. It is preferably at most 45%.

The glass ceramic composition A consists essentially of the above components, but may sometimes contain other components, such as ceramic powders other than the alumina powder, within a range not to impair the purpose of the present invention. In a case where such other components are to be contained, the total of their contents is preferably at most 10%, more preferably at most 5%.

A ceramic powder to be added to the glass ceramic composition A is typically at least one ceramic powder selected from the group consisting of mullite, forsterite, enstatite, magnesia, anorthite and cordierite.

In a case where it is desired to increase α of the fired product, forsterite, enstatite or magnesia powder is preferably contained. When a forsterite powder is to be contained, its content is typically from 1 to 10%.

Further, in a case where it is desired to suppress coloration resulting from firing together with a silver conductor, a cerium oxide powder is preferably contained, and its content is typically from 0.1 to 5%.

D₅₀ of the ceramic powder is preferably from 1 to 10 µm. If it is less than 1 µm, it tends to be difficult to uniformly disperse the ceramic powder in e.g. a green sheet. It is more preferably at least 1.5 µm. If it exceeds 10 µm, a dense fired product tends to be hardly obtainable. It is more preferably at most 5 µm, typically at most 3 µm.

Now, the glass powder B contained in the raw material layer B will be described. D₅₀ of the glass powder B is preferably from 0.5 to 10 µm. If it is less than 0.5 µm, it tends to be difficult to uniformly disperse the glass powder in e.g. a green sheet. It is more preferably at least 1 µm, particularly preferably at least 1.5 µm. If it exceeds 10 µm, a dense fired product tends to be hardly obtainable. It is more preferably at most 7 µm, particularly preferably at most 5 µm, typically at most 3 µm.

Tg of the glass powder B is typically from 650 to 780°C.

Tg of the glass powder B is higher by at least 50°C, preferably at least 70°C, than Tg of the glass powder A contained in the raw material layer A adjacent to the raw material layer B.

Ts of the glass powder B is preferably at most 910°C. If Ts exceeds 910°C, a dense fired product may not be obtainable when firing is carried out at a temperature of at most 900°C. Further, Ts is typically at least 800°C.

The glass powder B is preferably one wherein crystals will precipitate when fired typically at a temperature of from 850 to 900°C. If no crystals will precipitate, the mechanical strength of the fired product (dielectric layer) is likely to be low.

Further, Tc of the glass powder B is preferably at most 850°C. If it exceeds 850°C, the dimensional precision of the laminated dielectric material is likely to be low.

In a case where it is desired to reduce tanδ of the fired product, the glass powder B is preferably one wherein, when fired, at least one type of crystals selected from the group consisting of forsterite, enstatite, diopside and anorthite will precipitate, more preferably one wherein forsterite crystals will precipitate.

The composition of the glass powder B will be described below.

SiO₂ is a network former of glass and is essential. If it is less than 45%, it tends to be difficult to obtain a stable glass, or the shrinkage of the laminate tends to be large, whereby the dimensional precision tends to be low. It is preferably at least 48%. If it exceeds 55%, Ts or Tg tends to be too high. It is preferably at most 52%.

B₂O₃ is not essential, but may be contained up to 5% in order to e.g. stabilize the glass. If it exceeds 5%, tanδ of the fired product is likely to be large, or the chemical durability is likely to be low.

Al₂O₃ is a component to increase the stability or chemical durability of the glass and is essential. If it is less than 2%, the glass tends to be unstable. It is preferably at least 5%, more preferably at least 6%. If it exceeds 20%, Ts or Tg tends to be too high. It is preferably at most 10%, more preferably at most 8.5%.

The total content of SiO₂ and Al₂O₃ is preferably at least 66%. If it exceeds 66%, Ts tends to be high, and it tends to be difficult to obtain a dense fired product when fired at a temperature of at most 900°C.

MgO has an effect to stabilize glass or to promote precipitation of crystals from the glass and is essential. If it is less than 20%, the above effect tends to be inadequate. It is preferably at least 25%. If it exceeds 45%, the glass tends to be unstable. It is preferably at most 40%, more preferably at most 38%.

CaO is not essential, but may be contained up to 20% for the purpose of e.g. stabilizing the glass or lowering tanδ of the fired product. Further, CaO is a component constituting diopside or anorthite, and when it is desired to precipitate such crystals, its content is preferably at least 5%, more preferably at least 7%. In a case where it is desired to precipitate anorthite, CaO is particularly preferably contained in an amount of at least 14%. If CaO exceeds 20%, the glass is likely to be unstable, and it is preferably at most 18%. In a case where it is not desired to precipitate anorthite, CaO is preferably at most 12%.

SrO is not essential, but may be contained for the purpose of e.g. lowering tanδ of the fired product. In a case where SrO is contained, its content is typically at most 10%.

In a case where CaO or SrO is contained, their total content is at most 20%.

BaO is not essential, but may be contained up to 10% in order to e.g. stabilize glass. If it exceeds 10%, tanδ of the fired product is likely to be large.

ZnO is not essential, but may be contained up to 15% in order to e.g. lower Ts or Tg. If it exceeds 15%, the chemical durability, particularly acid resistance, of the glass tends to be low. It is preferably at most 10%, more preferably at most 8%. In a case where ZnO is contained, its content is preferably at least 2%.

Each of Ti₂O, Zr₂O and SnO₂ is not essential, but they may be contained in their total amount of 10% in order to e.g. increase the chemical durability of glass, to increase the crystallization ratio of the fired product, etc. If the total amount of such components exceeds 10%, Ts tends to be too high, or the denseness of the fired product is likely to be low. Their total amount is typically at most 5%.

It is preferred that SiO₂ is from 40 to 55%, Al₂O₃ is from 5 to 10%, MgO is from 28 to 40%, CaO is from 0 to 18%, and SnO₂ is from 0 to 5%.

This glass powder consists essentially of the above components, but may contain other components within a range not to impair the object of the present invention. For example, it may contain P₂O₅ or the like for the purpose of e.g. lowering the glass melting temperature, or may contain CuO, CoO, CeO₂, Y₂O₃, La₂O₃, Nd₂O₃, Sm₂O₃, Bi₂O₃, WO₃, etc. for the purpose of coloring glass or increasing the crystallization ratio.

In a case where such other components are contained, their contents are preferably at most 10% in total. Further, the glass powder contains no lead oxide.

The raw material layer B is preferably a glass ceramic composition containing a ceramic powder in addition to the glass powder B.

A preferred embodiment of such a glass ceramic composition (hereinafter, this embodiment will be referred to as the glass ceramic composition B) will be described below by using mass percentage.

The glass ceramic composition B consists essentially of from 30 to 90% of the glass powder B and from 10 to 70% of a ceramic powder.

The glass powder B is a component to increase the denseness of the fired product. If it is less than 30%, the denseness tends to be inadequate. It is preferably at least 40%, more preferably at least 50%, typically at least 60%. If it exceeds 90%, the strength of the fired product tends to be low. It is preferably at most 85%, more preferably at most 80%.

The ceramic powder is a component to increase the strength of the fired product or to adjust α of the fired product. If it is less and 10%, the strength of the fired product tends to be low. It is typically at least 15%. If it exceeds 70%, the denseness of the fired product tends to be inadequate. It is typically at most 45%.

The ceramic powder is typically at least one ceramic powder selected from the group consisting of alumina, mullite, cordierite, forsterite and celsian.

In a case where it is, for example, desired to increase the strength of the fired product, an alumina powder is preferably contained.

In a case where it is, for example, desired to suppress coloring which is likely to occur when fired together with a silver conductor, the ceramic powder is preferably one containing a cerium oxide powder, and its content is typically from 0.1 to 10%.

D₅₀ of the ceramic powder is preferably from 1 to 12 µm. If it is less than 1 µm, it tends, for example, to be difficult to uniformly disperse the ceramic powder in a green sheet. It is more preferably at least 1.5 µm. If it exceeds 12 µm, a dense fired product tends to be hardly obtainable. It is more preferably at most 5 µm, typically at most 3.5 µm.

The glass ceramic composition B is one wherein crystals will precipitate, when it is fired, for example, at a temperature of from 850 to 900°C. Such crystals usually precipitate from the glass powder B.

Further, the glass powders A and B, as well as the glass ceramic compositions A and B, are selected so that the absolute value of the difference in α between any adjacent dielectric layers obtainable by firing raw material layers will be at most 15×10⁻⁷/°C.

### EXAMPLES

Materials were prepared and mixed to obtain a composition shown by mol% in sections for from SiO₂ to ZrO₂ in Tables 1 and 2, and the mixed materials were put in a platinum crucible, melted at a temperature of from 1,500 to 1,600°C for 60 minutes. Then, the molten glass was cast and cooled, whereby no vitrification was observed in the obtained glass.

The obtained glass was pulverized for from 20 to 60 hours in an alumina ball mill using ethyl alcohol as a solvent, to obtain glass powders G1 to G12. G1 to G4 are glass powders B, and G5 to G9 are glass powders A.

D₅₀ (unit: µm) of each glass powder was measured by using a laser diffraction particle size analyzer SALD21 00, manufactured by Shimadzu Corporation, and Tg (unit: °C), Ts (unit: °C) and crystallization peak temperature Tc (unit: °C) were respectively measured by using a thermal analyzer TG-DTA, manufactured by Rigaku Corporation up to 1,000°C under a temperature raising rate of 10°C/min.

Presence or absence of precipitation of crystals was examined by an X-ray diffraction method with respect to a fired product obtained by maintaining (firing) each glass powder at 900°C for two hours, whereby in the fired products of G1 to G4, MgSiO₃ crystals were found to have precipitated; in the fired products of G5 to G9, BaAl₂Si₂O₈ crystals, BaZn₂Si₂O₇ crystals, etc. were found to have precipitated; in the fired product of G10, BaAl₂Si₂O₈ crystals, CaAl₂Si₂O₈ crystals, SiO₂ crystals, etc. were found to have precipitated; in the fired product of G11, Ba₅Si₈O₂₁ crystals and Ba₅Al₂O₁₁ crystals were found to have precipitated; and in the fired product of G12, BaAl₂Si₂O₈ crystals and Ba₂Ti₉O₂0 crystals were found to have precipitated.

**TABLE 1**

| | G1 | G2 | G3 | G4 | G5 | G6 |
|---|---|---|---|---|---|---|
| SiO₂ | 50.0 | 50.0 | 50.0 | 55.0 | 56.4 | 50.2 |
| Al₂O₃ | 7.5 | 7.5 | 5.0 | 5.0 | 4.9 | 4.3 |
| MgO | 35.0 | 32.5 | 45.0 | 30.0 | 0 | 0 |
| CaO | 0 | 0 | 0 | 0 | 1.5 | 1.6 |
| BaO | 0 | 0 | 0 | 0 | 17.8 | 24.3 |
| ZnO | 7.5 | 10.0 | 0 | 10.0 | 16.8 | 16.4 |
| SnO₂ | 0 | 0 | 0 | 0 | 0.3 | 0.3 |
| Li₂O | 0 | 0 | 0 | 0 | 1.3 | 1.5 |
| ZrO₂ | 0 | 0 | 0 | 0 | 1.0 | 1.4 |
| D₅₀ | 3.9 | 3.6 | 4.3 | 3.7 | 2.3 | 2.3 |
| Tg | 751 | 730 | 753 | 739 | 655 | 655 |
| Tc | 943 | 944 | 930 | 932 | 885 | 910 |

**TABLE 2**

| | G7 | G8 | G9 | G10 | G11 | G12 |
|---|---|---|---|---|---|---|
| SiO₂ | 50.4 | 54.4 | 57.1 | 48.6 | 60.2 | 40.0 |
| Al₂O₃ | 7.0 | 6.7 | 4.9 | 12.3 | 3.8 | 5.0 |
| MgO | 0 | 0 | 0 | 6.2 | 0 | 0 |
| CaO | 0 | 0 | 0 | 12.5 | 0 | 7.5 |
| BaO | 24.4 | 21.3 | 18.8 | 8.1 | 36.0 | 15.0 |
| ZnO | 14.6 | 15.9 | 16.5 | 10.3 | 0 | 0 |
| SnO₂ | 0.3 | 0.3 | 0.3 | 0 | 0 | 0 |
| Li₂O | 1.5 | 1.4 | 1.4 | 0 | 0 | 0 |
| TiO₂ | 0 | 0 | 0 | 0 | 0 | 23.0 |
| ZrO₂ | 0 | 0 | 1.0 | 2.0 | 0 | 0 |
| D₅₀ | 2.6 | 2.8 | 2.4 | 2.0 | 1.6 | 1.8 |
| Tg | 652 | 653 | 657 | 720 | 705 | 681 |
| Tc | 856 | 875 | 894 | 915 | 880 | 867 |

Glass ceramic compositions GC1 to GC9 were prepared to have the compositions shown by mass percentage in sections for from Glass powder to BT powder in Table 3. As the glass, one shown in the section for Type of glass was used. GC1 is the glass ceramic composition B, and GC2 to GC6 are the glass ceramic composition A.

As alumina powder, AL-45H (D₅₀=3.0 µm) manufactured by Showa Denko K.K. was used, and as forsterite powder, F-300 (D₅₀-1.1 µm) manufactured by Titan Kogyo Kabushiki Kaisha was used.

BT powder is a powder prepared by the following method. That is, 88 g of BaCO₃ (barium carbonate BW-KT, manufactured by Sakai Chemical Industry Co., Ltd.) and 130 g of TiO₂ (reagent rutile type, manufactured by Kanto Chemical Co., Inc.) were mixed in a ball mill by using water as a solvent, dried and then maintained at 1,150°C for two hours. Thereafter, pulverization was carried out for 60 hours by a ball mill to obtain a powder having D₅₀ of 0.9 µm. This powder was subjected to X-ray diffraction measurement, whereby a strong diffraction peak pattern of BATi₄O₉ crystals was observed.

From 4 to 5 g of each of GC1 to GC9 was press-molded by means of a mold and maintained at 875°C for two hours for firing to obtain a fired product, which was subjected to polishing processing to obtain a columnar sample having a diameter of about 13 mm and a height of about 10 mm.

With respect to such a sample, the dielectric constant and the dielectric loss tangent were measured by using a network analyzer and a parallel conductor resonance dielectric constant measuring system manufactured by KEYCOM Corporation, at (9±1.5)GHz with respect to GC1 to GC8, and at 6.3GHz with respect to GC9. The results are shown in Table 3.

Further, to 50 g of GC1, 15 g of an organic solvent (one having toluene, xylene, 2-propanol and 2-butanol mixed in a mass ratio of 4:2:2:1),2.5 g of a plasticizer (di-2-ethylhexyl phthalate), 5 g of a resin (polyvinyl butyral (PVK#3000K, manufactured by Denka) and a dispersing agent (BYK180 manufactured by BYK-Chemie) were mixed to obtain a slurry. This slurry was applied on a PET film by a doctor blade method and then dried to obtain a green sheet S1 having a thickness of 0.2 mm. Further, using GC2 to GC9, green sheets S2 to S8 were prepared in the same manner.

Six sheets of green sheet S1 were laminated and press-bonded under a pressure of 10 MPa for one minute. The press bonded product (product to be fired) was maintained at 550°C for 5 hours to decompose and remove the resin component, and then maintained at 875°C for two hours for firing to prepare a fired product for strength test.

This fired product was processed into a strip specimen having a width of 5 mm and a length of 20 mm, and by using a differential thermal expansion meter DILATOMETER, manufactured by MAC Science Co., Ltd., the above-mentioned expansion coefficient α (unit: 10⁻⁷/°C) was measured.

Further, with respect to the fired product for strength test, a three point bending strength (unit: MPa) was measured. The span was 15 mm, and the cross head speed was 0.5 cm/min.

By using green sheets S2 to S6, the expansion coefficient and the three point bending strength were measured with respect to the fired products of GC2 to GC6 in the same manner.

The results of these measurements are shown in Table 3.

**TABLE 3**

| | GC1 | GC2 | GC3 | GC4 | GC5 | GC6 | GC7 | GC8 | GC9 |
|---|---|---|---|---|---|---|---|---|---|
| Type of glass | G1 | G5 | G5 | G6 | G6 | G5 | G10 | G11 | G12 |
| Glass powder | 75 | 68 | 75 | 60 | 70 | 90 | 65 | 80 | 50 |
| Alumina powder | 25 | 28 | 25 | 40 | 30 | 10 | 25 | 20 | 0 |
| Forsterite powder | 0 | 7 | 0 | 0 | 0 | 0 | 10 | 0 | 0 |
| BT powder | 0 | 0 | 0 | 0 | 0 | 0 | 0 | 0 | 50 |
| Expansion coefficient | 83 | 95 | 80 | 84 | 85 | 81 | 75 | 95 | 82 |
| Dielectric constant | 6.9 | 8.0 | 8.0 | 7.7 | 8.9 | - | 5.2 | - | 18 |
| Dielectric loss tangent | 0.0013 | 0.0018 | 0.0016 | 0.0015 | 0.0020 | - | 0.0031 | - | 0.0024 |
| Strength | 270 | 230 | 235 | 154 | 170 | 154 | - | - | - |
| Shrinkage | 14.5 | 13.1 | 14.5 | 11.0 | 13.7 | 16.2 | 10.6 | 6.6 | 12.6 |

### EXAMPLE 1

S1 (GC1) and S2 (GC2) were, respectively, cut into 40 mm x 40 mm, and two sheets of S1, four sheets of S2 and two sheets of S1 i.e. a total of eight green sheets were laminated in this order to obtain a raw material layer laminate. Ones having two sheets of S1 laminated constitute glass powder-containing raw material layers which will become the first and third dielectric layers when fired, and one having four sheets of S2 laminated constitutes a glass powder-containing raw material layer which will become the second dielectric layer when fired.

Then, this raw material layer laminate was press bonded under a pressure of 10 MPa for one minute. In the obtained press bonded product, four punch holes were formed so that they were located at four corners of a square of 30 x 30 mm, and it was maintained at 550°C for 5 hours to decompose and remove the resin component, and then maintained at 750°C for one hour and further maintained at 875°C for 1.5 hours for firing to prepare a laminated dielectric material. The length of one side of the square formed by the above-mentioned punch holes in this laminated dielectric material was measured under the microscope, and the shrinkage was calculated and found to be 3.1 %. Such a shrinkage is preferably at most 5%.

Further, the three point bending strength of this laminated dielectric material was measured in the same manner as in the previous measurement of the three point bending strength of the fired product of GC1, and found to be 240 MPa. Such a strength is preferably at least 200 MPa.

The results of these measurements are shown in the column for Example 1 in Table 4. EXAMPLES 2 to 8

Laminated dielectric materials of Examples 2 to 8 were prepared by using the raw material laminates having the layered structures as shown in Table 4, in the same manner as in Example 1. Here, Examples 6 to 8 are Comparative Examples, and in Example 6, during the processing, the fired product was broken, and in Examples 7 and 8, the three point bending strength was not measured.

The results of measurements of the shrinkage and the three point bending strength are shown in Table 4.

**TABLE 4**

| | Ex. 1 | Ex. 2 | Ex. 3 | Ex. 4 | Ex. 5 | Ex. 6 | Ex. 7 | Ex. 8 |
|---|---|---|---|---|---|---|---|---|
| First and third layers | GC1 | GC1 | GC1 | GC1 | GC1 | GC1 | GC1 | GC1 |
| Second layer | GC2 | GC3 | GC4 | GC5 | GC6 | GC7 | GC8 | GC9 |
| Shrinkage | 3.1 | 3.0 | 3.5 | 3.1 | 12.2 | 10.3 | 6.6 | 10.3 |
| Strength | 240 | 192 | 233 | 259 | 225 | Broken | - | - |

### EXAMPLE 9

S1 (GC1), S2 (GC2) and S9 (GC9) were, respectively, cut into 40 mm x 40 mm, and two sheets of S1, two sheets of S2, two sheets of S1, one sheet of S9, two sheets of S1, two sheets of S2 and two sheets of S1 i.e. a total of 13 green sheets, were laminated in this order to obtain a raw material layer laminate, and the shrinkage was measured in the same manner as in Example 1 and found to be 3.4%.

In this Example 9, a raw material laminate having raw material layer B, raw material layer A, raw material layer B, S9, raw material layer B, raw material layer A and raw material layer B laminated in this order, is used and represents an Example for the above-mentioned first method, which should be compared with the above Comparative Example 8. That is, the shrinkage in Example 9 as a Working Example of the present invention is remarkably reduced as compared with the above Example 8 as a Comparative Example.

### INDUSTRIAL APPLICABILITY

The method of the present invention is useful as a method for producing a laminated dielectric material suitable for e.g. a substrate for e.g. antennas or circuits for small size electronic equipments such as cell phones to be used in a high frequency region such as a microwave region.

The entire disclosure of Japanese Patent Application No. 2007-115724 filed on April 25, 2007 including specification, claims, drawings and summary is incorporated herein by reference in its entirety.

## Claims

1. A method for producing a laminated dielectric material wherein n dielectric layers (where n is an integer of at least 3) are laminated so that the absolute value of the difference in the average linear expansion coefficient at from 50 to 350°C between any adjacent dielectric layers is at most 15×10⁻⁷/°C, which comprises laminating and firing n glass powder-containing raw material layers which, upon being fired, become the above dielectric layers, wherein at least one glass powder-containing raw material layer among the glass powder-containing raw material layers to become the second to (n-1)th dielectric layers, comprises, as represented by mass percentage, from 50 to 80% of glass powder and from 20 to 50% of alumina powder; said glass powder comprises, as represented by mol% based on the following oxides, from 45 to 60% of SiO₂, from 0 to 10% of B₂O₃, from 2 to 10% of Al₂O₃, from 0 to 5% of CaO, from 10 to 30% of BaO, from 10 to 20% of ZnO, from 0 to 5% of Li₂O+Na₂O+K₂O, and from 0 to 5% of TiO₂+ZrO₂+SnO₂; and each of glass powders contained in two glass powder-containing raw material layers adjacent to said glass powder-containing raw material layer, comprises, as represented by mol% based on the following oxides, from 45 to 55% of SiO₂, from 0 to 5% of B₂O₃, from 2 to 20% of Al₂O₃, from 20 to 45% of MgO, from 0 to 20% of CaO+SrO, from 0 to 10% of BaO, from 0 to 15% of ZnO, and from 0 to 10% of TiO₂+ZrO₂+SnO₂ and its glass transition temperature is higher by at least 50°C than the glass transition temperature of the glass powder of the glass powder-containing raw material layer sandwiched by said two glass powder-containing raw material layers.

2. The method for producing a laminated dielectric material according to Claim 1, wherein TiO₂+ZrO₂+SnO₂ in the glass powders contained in said two glass powder-containing raw material layers is from 0 to 5 mol%.

3. A method for producing a laminated dielectric material wherein n dielectric layers (where n is an integer of at least 3) are laminated so that the absolute value of the difference in the average linear expansion coefficient at from 50 to 350°C between any adjacent dielectric layers is at most 15×10⁻⁷/°C, which comprises laminating and firing n glass powder-containing raw material layers which, upon being fired, become the above dielectric layers, wherein at least one glass powder-containing raw material layer among the glass powder-containing raw material layers to become the second to (n-1)th dielectric layers, contains a glass powder which comprises, as represented by mol% based on the following oxides, from 45 to 55% of SiO₂, from 0 to 5% of B₂O₃, from 2 to 20% of Al₂O₃, from 20 to 45% of MgO, from 0 to 20% of CaO+SrO, from 0 to 10% of BaO, from 0 to 15% of ZnO, and from 0 to 10% of TiO₂+ZrO₂+SnO₂; and each of two glass powder-containing raw material layers adjacent to said glass powder-containing raw material layer, comprises, as represented by mass percentage, from 50 to 80% of glass powder and from 20 to 50% of alumina powder, wherein said glass powder comprises, as represented by mol% based on the following oxides, from 45 to 60% of SiO₂, from 0 to 10% of B₂O₃, from 2 to 10% of Al₂O₃, from 0 to 5% of CaO, from 10 to 30% of BaO, from 10 to 20% of ZnO, from 0 to 5% of Li₂O+Na₂O+K₂O, and from 0 to 5% of TiO₂+ZrO₂+SnO₂ and its glass transition temperature is lower by at least 50°C than the glass transition temperature of the glass powder of the glass powder-containing raw material layer sandwiched by said two glass powder-containing raw material layers.

4. The method for producing a laminated dielectric material according to Claim 3, wherein TiO₂+ZrO₂+SnO₂ in the glass powder contained in said at least one glass powder-containing raw material layer is from 0 to 5 mol%.

5. The method for producing a laminated dielectric material according to any one of Claims 1 to 4, wherein the glass transition temperature of the glass powder in the glass powder-containing raw material layer comprising, as represented by mass percentage, from 50 to 80% of glass powder and from 20 to 50% of alumina powder, is from 550 to 700°C.

6. The method for producing a laminated dielectric material according to any one of Claims 1 to 5, wherein the glass powder-containing raw material layer comprising, as represented by mass percentage, from 50 to 80% of glass powder and from 20 to 50% of alumina powder, contains, as represented by mass percentage, from 1 to 10% of at least one ceramic powder selected from forsterite, enstatite and magnesia.

7. The method for producing a laminated dielectric material according to any one of Claims 1 to 6, wherein each dielectric layer in the laminated dielectric material has a dielectric loss tangent of at most 0.0050 at 9GHz.
